# EUROPEAN PATENT APPLICATION

(11) **EP 2 851 458 A1**
(43) Date of publication of application: **25.03.2015**
(21) Application number: 13791694.6
(22) Date of filing: 08.05.2013
(51) Int. Cl.: C30B 29/16, C30B 15/24

(54) **MONOCRYSTALLINE GALLIUM OXIDE AND MONOCRYSTALLINE GALLIUM OXIDE SUBSTRATE**

(30) Priority: 16.05.2012 JP 2012112115
(71) Applicant: Namiki Seimitsu Houseki kabushikikaisha, Adachi-ku Tokyo 123-8511 (JP)
(72) Inventor: AIDA, Hideo, Tokyo 123-8511 (JP); NISHIGUCHI, Kengo, Tokyo 123-8511 (JP); KOYAMA, Kouji, Tokyo 123-8511 (JP); IKEJIRI, Kenjiro, Tokyo 123-8511 (JP); NAKAMURA, Motoichi, Tokyo 123-8511 (JP)
(74) Representative: Prinz & Partner mbB
(86) International application number: PCT/JP2013/062905
(87) International publication number: WO 2013/172227

(57) **Abstract**

Provided is a gallium oxide single crystal and a gallium oxide single crystal substrate that can improve the luminous efficiency. In a gallium oxide single crystal 13, the dislocation density is less than or equal to 3.5 × 10⁶ / cm². The gallium oxide single crystal 13 is manufactured by the EFG method. Further, the seed touch temperature in the EFG method is greater than or equal to 1930 degrees centigrade and less than or equal to 1950 degrees centigrade. A neck part 13a of the gallium oxide single crystal 13 is less than or equal to 0.8 mm. A gallium oxide single crystal substrate 21 is made of the gallium oxide single crystal 13.

## Description

### TECHNICAL FIELD

The present invention relates to a gallium oxide single crystal and a gallium oxide single crystal substrate.

### BACKGROUND ART

Ga₂O₃ substrates made of a gallium oxide (Ga₂O₃) single crystal have been used for making a light emitting device by coating GaN-base thin film device, for example. Various methods have been proposed to manufacture such a Ga₂O₃ single crystal. The EFG (Edge Defined Film Fed Growth) method has been paid attention to as a crystal growth method for manufacturing a large single crystal substrate.

For example, Patent Document 1 discloses providing a die having a slit provided vertically in a crucible used for accepting Ga₂O₃ melt, causing the seed crystal to come into contact with the Ga₂O₃ melt moved up in the slit provided within the cross section of the die, and then drawing up the seed crystal to obtain the Ga₂O₃ single crystal with a predetermined size and shape.

### CITATION LIST

### PATENT LITERATURE

Patent document 1: JP-A--2004-56098

### SUMMARY OF INVENTION

### PROBLEM TO BE SOLVED BY THE INVENTION

By the way, in the crystal such as the Ga₂O₃ single crystal used for the growth substrate of the GaN-base thin film device, it is preferable that the atoms be in an ideal periodical alignment. In the actual crystal growth, however, the positions of the atoms aligned in a line can be collectively shifted by the thermal shock when the seed crystal is caused to come into contact with the melt and by the growth at an improper crystal growth rate. Such a linear crystal defect is referred to as dislocation.

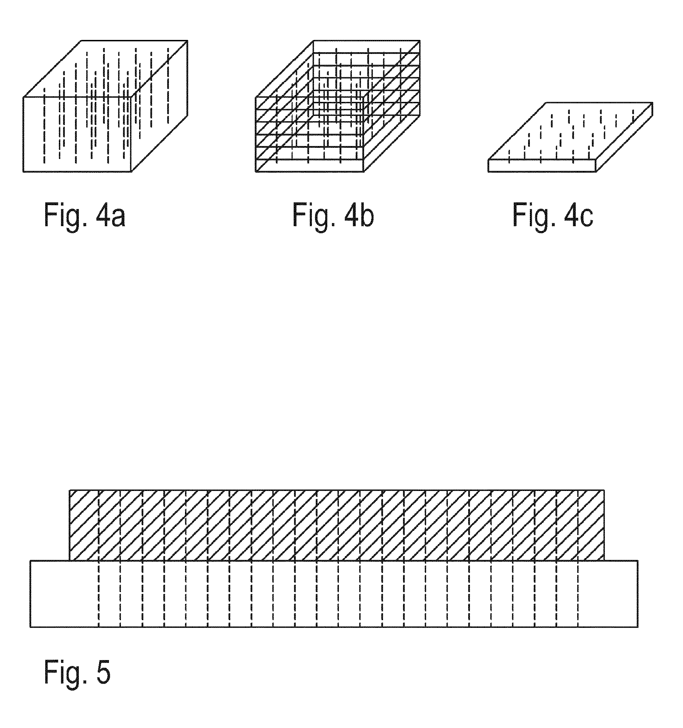

Generally, in order to obtain a high luminous efficiency, it is preferable to use the Ga₂O₃ single crystal substrate having no dislocation. However, it is difficult to obtain the Ga₂O₃ single crystal substrate having no dislocation. The Ga₂O₃ single crystal substrates provided by the current crystal growth technique include finite dislocations. When a substrate is fabricated by using such a single crystal, the dislocations appear differently on the primary surface of the substrate depending on the relationship between the dislocating direction in the crystal and the cutting direction of the crystal. For example, when a slicing machining is applied by cutting the crystal vertically to the dislocating direction, many dislocations appear on the primary surface of the substrate as illustrated by dashed lines in FIG. 4(a) to FIG. 4(c).

When a device, for example, a GaN-base LED is fabricated on the Ga₂O₃ substrate having the dislocations on its surface, the dislocations on the Ga₂O₃ substrate (dashed lines) are propagated to the grown GaN layer (including the light emitting layer) represented by the hatching, as illustrated in FIG. 5. Thus, there arises a problem that the dislocation density in the light emitting layer increases and therefore the luminous efficiency decreases.

The present invention has been made in view of the above problem. The purpose of the present invention is to provide a gallium oxide single crystal and a gallium oxide single crystal substrate that can improve the luminous efficiency.

### SOLUTIONS TO THE PROBLEMS

In order to achieve the above purpose, a gallium oxide single crystal according to the first aspect of the present invention is featured in that the dislocation density is less than or equal to 3.5 × 10⁶ / cm².

It is preferable that this be manufactured by an EFG method and that the neck diameter is less than or equal to 0.8 mm.

Further, it is preferable that the seed touch temperature in the EFG method be greater than or equal to 1930 degrees centigrade and less than or equal to 1950 degrees centigrade.

A gallium oxide single crystal substrate according to the second aspect of the present invention is featured to be made of the gallium oxide single crystal according to the first aspect.

Further, this is preferably at least one-inch size.

### ADVANTAGEOUS EFFECTS OF THE INVENTION

According to the present invention, the luminous efficiency can be improved.

### BRIEF DESCRIPTION OF THE DRAWINGS

FIG. 1(a) is a schematic sectional view illustrating a growing furnace in an example of a manufacturing method of a gallium oxide single crystal by an EFG method. FIG. 1(b) is a partial enlarged view illustrating a seed crystal, a gallium oxide single crystal, and a gallium oxide melt part on a die top of FIG. 1(a).
FIG. 2 is a general view of the gallium oxide single crystal fabricated by the EFG method.
FIG. 3 is a view illustrating a relationship between necking conditions and the dislocation density of the gallium oxide single crystal.
FIG. 4(a) is a schematic view of a state where the dislocations appear on a surface of the Ga₂O₃ single crystal. FIG. 4(b) is a schematic view illustrating a state where a slicing machining is applied to the Ga₂O₃ single crystal of FIG. 4(a) vertically to the dislocating direction. FIG. 4(c) is a view for illustrating a state where the dislocations appear on the substrate surface that is a schematic view illustrating the Ga₂O₃ single crystal substrate containing penetrating dislocations.
FIG. 5 is a view for illustrating a state where the luminous efficiency decreases.

### DESCRIPTION OF EMBODIMENTS

A gallium oxide single (Ga₂O₃) crystal and a gallium oxide single crystal substrate of the present invention will be described below by referring to the drawings.

In the gallium oxide single crystal of the present invention, its dislocation density is less than or equal to 3.5 × 10⁶ / cm². In this way, when the gallium oxide single crystal substrate is fabricated by using the gallium oxide single crystal having a small dislocation density (having few dislocations) and a GaN epitaxial film is fabricated on this gallium oxide single crystal substrate, the loss of the luminous efficiency from the light emitting layer of the GaN film can be suppressed to 10 % or below. Therefore, with the dislocation density of the gallium oxide single crystal being less than or equal to 3.5 × 10⁶ / cm², the luminous efficiency can be improved.

The dislocation density of the gallium oxide single crystal is preferably less than or equal to 3.5 × 10⁶ / cm², more preferably less than or equal to 1 × 10⁶ / cm², and the most preferably less than or equal to 5 × 10⁵ / cm². With such ranges being employed, the luminous efficiency can be further improved. It is noted that, the lower limit of the dislocation density of the gallium oxide single crystal is not restricted as long as the gallium oxide single crystal can be manufactured (grown). This lower limit is set to exceed 0 / cm².

The dislocation density of the gallium oxide single crystal of the present case is measured by observing the dislocations as the light and shade pattern by the transmission electron microscope (TEM) and counting the number thereof. When the dislocation density is 1 × 10⁴ / cm² or less, it is possible to measure the dislocations as the light and shade pattern by mapping the diffraction X-ray intensities by means of the X-ray topograph method.

Further, the dislocation density is controllable by properly selecting the neck diameter and the seed touch temperature. As a method for obtaining the gallium oxide single crystal containing the above-described dislocations, it is preferable that its neck diameter (the diameter of a neck part 13a described later) be less than or equal to 1.4 mm. This is because the reduction in the neck diameter of the gallium oxide single crystal facilitates the reduction in the dislocation density. The neck diameter of the gallium oxide single crystal is preferably less than or equal to 1.2 mm, and more preferably less than or equal to 1.0 mm. In particular, when the neck diameter of the gallium oxide single crystal is less than or equal to 0.8 mm, the dislocation density can be easily controlled to be less than or equal to 3.5 × 10⁶ / cm². Further, the lower limit of the neck diameter of the gallium oxide single crystal is not restricted as long as it is the diameter at which the gallium oxide single crystal can be manufactured (grown). This lower limit is preferably 0.2 mm or greater in taking into consideration of the handling of the grown single crystal.

The gallium oxide single crystal substrate of the present invention is a substrate that has been cut out in a predetermined size, for example, one-inch size from the gallium oxide single crystal whose dislocation density is less than or equal to 3.5 × 10⁶ / cm². When the gallium oxide single crystal substrate is used for a semiconductor device substrate, it is necessary to flatten its surface in an atomic order. In a finishing processing for this purpose, a CMP (Chemical Mechanical Polish) processing is applied. It is noted that the CMP processing is a processing in which the chemical etching effect is combined with the mechanical processing.

Next, described will be the manufacturing method of the above-described gallium oxide single crystal and the gallium oxide single crystal substrate. In the present embodiment, description will be provided with an example of the case where the gallium oxide single crystal is manufactured by the crystal growth by an EFG (Edge Defined Film Fed Growth) method.

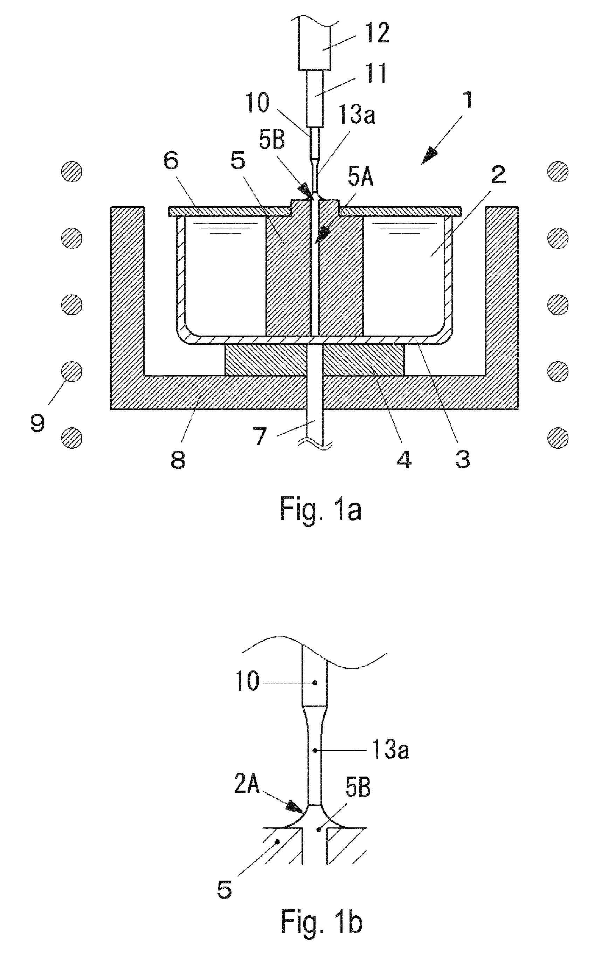

The EFG method is a method for manufacturing (growing) the gallium oxide single crystal as described below. The gallium oxide row material is supplied and heated in a crucible in which a die having a slit is accommodated. The melt of the gallium oxide row material that has extravasated over the slit is caused to come into contact with a seed crystal via the slit. FIG. 1(a) is a schematic sectional view illustrating a growing furnace in an example of the manufacturing method of the gallium oxide single crystal by the EFG method. FIG. 1(b) is a partial enlarged view illustrating the seed crystal, the gallium oxide single crystal, and the gallium oxide melt part on the die top of FIG. 1(a). Firstly, the manufacturing method of the gallium oxide single crystal with the use of the manufacturing apparatus of the gallium oxide single crystal will be briefly explained.

As illustrated in FIG. 1(a), a crucible 3 for accepting gallium oxide melt 2 as a row material of the gallium oxide single crystal is disposed inside a manufacturing apparatus 1 for the gallium oxide single crystal. The crucible 3 is formed in a bottomed cylindrical shape and placed on a support stage 4. The temperature of the bottom surface of the crucible 3 is measured by thermocouples 7. The crucible 3 is formed of a metal material having a heat resistance, for example, iridium (Ir) so as to be able to accept the gallium oxide melt 2. A necessary amount of the row material is supplied in the crucible 3 by a not-shown row material supplying unit.

In the crucible 3, a die 5 is disposed. The die 5 is formed in substantially a rectangular parallelepiped shape, for example. One or a plurality of slits 5A extending from its lower part to the upper part (an opening 5B) is provided in the die 5. For example, in FIG. 1 (a), one slit 5A is provided in the die 5 at the center of its thickness direction. As the die 5, a desired die is used depending on the shape, the number, and the like of the gallium oxide single crystal to be manufactured.

The one slit 5A is provided over substantially the entire width of the die 5 along the thickness direction of the die 5 with a predetermined gap. The slit 5A has a function of causing the gallium oxide melt 2 to move up from the lower end of the die 5 to the opening 5B of the slit 5A by the capillarity phenomenon.

On the upper face of the crucible 3, a lid 6 is disposed. The lid 6 is formed in a shape so as to close the upper face of the crucible 3 except the die 5. Therefore, with the lid 6 being disposed on the upper face of the crucible 3, the upper face of the crucible 3 except the opening 5B of the slit 5A is closed. In this way, the lid 6 prevents the gallium oxide melt 2 at a high temperature from being evaporated from the crucible 3. Furthermore, the lid 6 suppresses the attachment of the vapor of the gallium oxide melt 2 to other parts than the upper face of the slit 5A.

Further, a heater unit 9 made of a high-frequency coil, for example, is disposed around a heat insulator 8 provided to surround the crucible 3. The heater unit 9 causes the crucible 3 to be heated to a predetermined temperature. Furthermore, the row material in the crucible 3 is melted to be the gallium oxide melt 2. The melting temperature of the row material can be identified as, for example, the temperature at which the gallium oxide particle placed on the opening 5B of the die 5 is melted (chip melt). The heat insulator 8 is disposed so as to be spaced from the crucible 3 by a predetermined gap. The heat insulator 8 has a heat retaining property so as to suppress a rapid change of the temperature in the crucible 3 heated by the heater unit 9.

Further, at the upper part of the slit 5A, a seed crystal holding member 11 for holding a seed crystal 10 is disposed. The seed crystal holding member 11 is connected to a shaft 12 for supporting the seed crystal holding member 11 (the seed crystal 10) so as to be able to move it up and down.

Further, the melt 2A on the die top moved up by the capillarity phenomenon and exposed in the opening 5B is caused to come into contact with the seed crystal 10 (a seed touch) by moving down the seed crystal holding member 11 by the shaft 12. Furthermore, a thin neck part 13a is formed by moving up the seed crystal holding member 11 by the shaft 12 (a necking process) (see FIG. 1(b)). Then, a spread part 13b is grown by crystal-growing a single crystal 13 so as to expand in the width direction of the die 5 (a spreading process). After the width of the single crystal 13 is spread up to the width of the die 5 (a full spread), a straight body part 13c having the same width as the die 5 is grown (a straight body process).

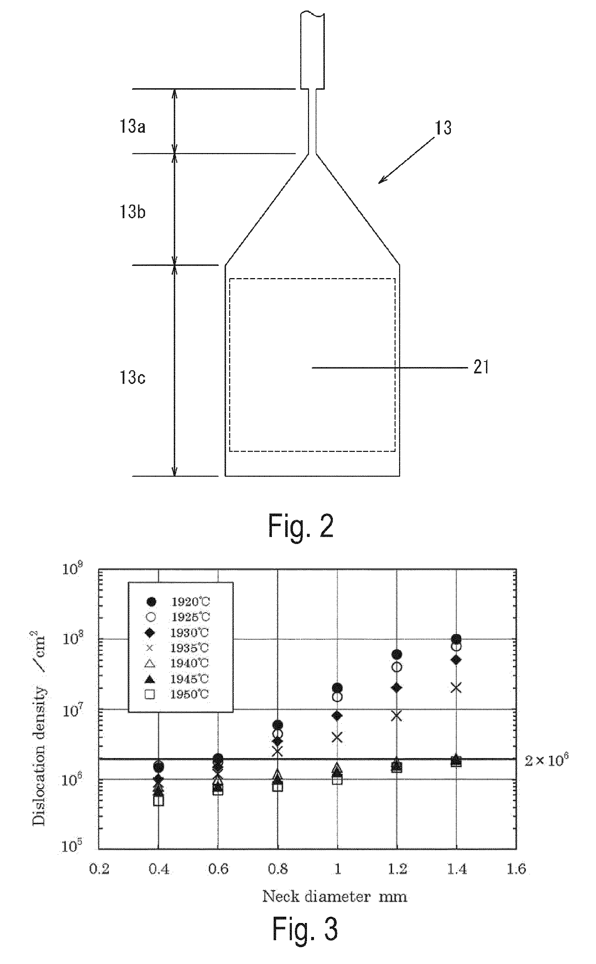

FIG. 2 illustrates a general view of the gallium oxide single crystal 13 manufactured (grown) by the above manufacturing apparatus for the gallium oxide single crystal. As illustrated in FIG. 2, the gallium oxide single crystal 13 is formed in substantially a sheet-like shape. The gallium oxide single crystal 13 is formed so as to have a crystal shape corresponding to the growing process. The gallium oxide single crystal 13 includes the neck part 13a formed at the necking process, the spread part 13b formed at the spreading process, and the straight body part 13c formed at the straight body process. It is noted that, typically, it is the crystal of the straight body part 13c that is utilized as a gallium oxide single crystal substrate 21.

In such a manufacturing method of the gallium oxide single crystal, for obtaining the gallium oxide single crystal of the present invention whose dislocation density is less than or equal to 3.5 × 10⁶ / cm², there is a method of growing the gallium oxide single crystal while reducing the dislocations of the neck part 13a. Specifically, in the necking process, the seed touch is made by increasing the displayed temperature of the thermocouples 7 at the seed touch (the seed touch temperature) as much as possible in order to reduce the thermal shock when the seed crystal comes into contact with the melt, and the diameter of the neck part 13a (the neck diameter) is fabricated thin in order to reduce the number of dislocations occurring in the neck part 13a.

The gallium oxide single crystal whose dislocation density was controlled by the above-described method was cut out to obtain a one-inch substrate. A GaN substrate was obtained by coating a GaN film on this substrate, and a GaN-base LED device was fabricated by a known approach. In order to evaluate the luminous efficiency, the LED that was on the way of fabrication in which the coating was applied up to the light emitting layer was taken out and its cathode luminescence (CL) image was observed. As a result, the part on the GaN substrate surface where the dislocations occurred became a non-light emitting area where the dislocations were propagated to the light emitting layer.

Table 1 indicates the evaluated results of the dislocation density, the dislocation density on the GaN film surface, and the luminous efficiency of the light emitting layer of the gallium oxide substrates that have been fabricated from the gallium oxides having the different dislocation densities. It is noted that the luminous efficiency is defined to be the ratio of the light emitting area to the observed area when the CL image is observed. According to the above, it became clear that the dislocation density of the gallium oxide substrate being less than or equal to 3.5 × 10⁶ / cm² allows the luminous efficiency to be 90 % or higher.

Further, Table 1 also illustrates the necking conditions (the neck diameter and the seed touch temperature) of the gallium oxide single crystal used for the fabrication of respective substrates.

**[Table 1]**

| Number | Ga₂O₃ substrate dislocation density (number / cm²) | GaN film dislocation density (number / cm²) | Luminous efficiency (%) | Neck diameter (mm) | Seed touch temperature (degrees centigrade) |
|---|---|---|---|---|---|
| 1 | 5.0E+05 | 5.0E+09 | 99 | 0.4 | 1950 |
| 2 | 1.0E+06 | 1.0E+10 | 97 | 0.6 | 1940 |
| 3 | 1.2E+06 | 1.2E+10 | 97 | 0.6 | 1935 |
| 4 | 3.5E+06 | 3.5E+10 | 90 | 0.8 | 1930 |
| 5 | 8.0E+06 | 8.0E+10 | 77 | 1.0 | 1930 |
| 6 | 1.5E+07 | 1.5E+11 | 57 | 1.0 | 1925 |
| 7 | 2.0E+07 | 2.0E+11 | 43 | 1.0 | 1920 |
| 8 | 5.0E+07 | 5.0E+11 | 1 | 1.4 | 1930 |

In view of the above results, the search was made for the necking conditions where the crystal whose dislocation density is less than or equal to 3.5 × 10⁶ / cm² can be obtained. FIG. 3 illustrates the dislocation densities of the gallium oxide single crystals when the neck diameter is changed from 0.4 to 1.4 mm and the seed touch temperature is changed from 1920 to 1950 degrees centigrade. Thereby, growing the gallium oxide single crystal under the condition where the seed touch temperature is in the temperature range greater than or equal to 1930 degrees centigrade and the neck diameter is less than or equal to 0.8 mm allows the dislocation density of the gallium oxide single crystal to be less than or equal to 3.5 × 10⁶/cm².

As having been described above, according to the present embodiments, the dislocation density of the gallium oxide single crystal is less than or equal to 3.5 × 10⁶ / cm². Therefore, the use of this gallium oxide single crystal allows for the suppression of the loss in the luminous efficiency from the light emitting layer of the GaN film, so that the luminous efficiency can be improved.

It is noted that the present invention is not limited to the above-described embodiments, but various modifications and applications thereof are possible. For example, in the above-described embodiments, the present invention has been described with the example of the case where the gallium oxide single crystal is manufactured by the crystal growth method by means of the EFG method. However, the manufacturing method of the gallium oxide single crystal is not limited to the EFG method, but various methods that are able to form the gallium oxide single crystal whose dislocation density is less than or equal to 3.5 × 10⁶/cm² can be used.

### INDUSTRIAL APPLICABILITY

The present invention is useful for gallium oxide single crystals and gallium oxide single crystal substrates according to the present invention.

### LIST OF REFERENCE NUMERALS

- 1: Manufacturing apparatus for gallium oxide single crystal
- 2: Gallium oxide melt
- 3: Crucible
- 4: Support stage
- 5: Die
- 5A: Slit
- 5B: Opening
- 6: Lid
- 7: Thermocouples
- 8: Heat isolator
- 9: Heater unit
- 10: Seed crystal
- 11: Seed crystal holding member
- 12: Shaft
- 13: Gallium oxide single crystal
- 21: Gallium oxide single crystal substrate

## Claims

1. A gallium oxide single crystal whose dislocation density is less than or equal to 3.5 × 10⁶ / cm².

2. The gallium oxide single crystal according to claim 1 manufactured by an EFG method, wherein a neck diameter is less than or equal to 0.8 mm.

3. The gallium oxide single crystal according to claim 2, wherein a seed touch temperature in the EFG method is greater than or equal to 1930 degrees centigrade and less than or equal to 1950 degrees centigrade.

4. A gallium oxide single crystal substrate comprising the gallium oxide single crystal according to any one of claims 1 to 3.

5. The gallium oxide single crystal substrate according to claim 4 that is at least one-inch size.
